# FASCICULE DE BREVET EUROPEEN

(11) **EP 1 526 644 B1**
(45) Date de publication et mention de la délivrance du brevet: **26.08.2009**
(21) Numéro de dépôt: 04024891.6
(22) Date de dépôt: 20.10.2004
(51) Int. Cl.: H03K 17/94

(54) **Tableau de commande pour planche de bord de véhicule automobile d'au moins un bouton rotatif réglable à commande optique**
Bedienfeld für Kraftfahrzeug-Armaturenbrett mit mindestens einem Drehknopf mit optischer Abtastung
Control panel for the dashboard of an automotive vehicule containing at least one adjustable rotatable knob with an optical command

(30) Priorité: 20.10.2003 FR 0312226
(43) Date de publication de la demande: 27.04.2005
(73) Titulaire: VALEO SYSTEMES THERMIQUES, 78320 Le Mesnil Saint-Denis (FR)
(72) Inventeur: Huynh, Tan Duc, 93330 Neuilly sur Marne (FR)
(74) Mandataire: Croonenbroek, Thomas Jakob

(56) Documents cités:
- EP-A- 0 072 386
- EP-A- 0 492 621
- DE-A- 4 343 304
- JP-A- 55 095 422
- US-A- 4 074 128
- US-A- 4 644 156
- US-A- 4 806 751
- US-A- 5 347 123
- US-A- 5 672 865
- US-A1- 2003 189 478
- US-B1- 6 181 847
- PATENT ABSTRACTS OF JAPAN vol. 0041, no. 45 (E-029), 14 octobre 1980 (1980-10-14) -& JP 55 095422 A (MATSUSHITA ELECTRIC IND CO LTD), 19 juillet 1980 (1980-07-19)

## Description

L'invention se rapporte à un tableau de commande pour planche de bord de véhicule automobile muni d'au moins un bouton rotatif de réglage à commande optique.

Dans les véhicules automobiles actuels, les planches de bord présentent, notamment dans une zone de console centrale intégrant un tableau de commande, des boutons de réglages d'un appareil de ventilation, de chauffage et/ou de climatisation de l'habitacle. Il s'agit notamment de boutons rotatifs permettant par exemple, individuellement par zone ou globalement pour tout l'habitacle, de régler un paramètre tel que la température de confort, le débit et la répartition du flux d'air propulsé par un appareil de ventilation, de chauffage et/ou de climatisation monté dans ladite planche de bord.

Ces boutons rotatifs se présente en général en deux parties : une partie extérieure mobile en rotation portant des pictogrammes ou des symboles visuelles et accessible de la planche de bord par le conducteur ou un passager, et une partie fixe disposée sous la façade de la planche de bord et reliée à une carte électronique de pilotage avec laquelle la partie mobile coopère. En général, les composants soudés à la carte électronique sont disposés avec des tolérances dimensionnelles de fabrication et de positionnement adaptées à un montage électronique.

En particulier, dans le cas connu d'un bouton rotatif du type à incréments décrit par exemple dans le document DE 4 343 304 A ou le document US 4 644 156 A, le capteur optique est monté sur la carte électronique et dispose d'une extrémité connectée au bouton de commande. Un tel montage nécessite une tolérance dimensionnelle bien précise afin d'assurer la coopération du capteur optique et du bouton. D'autres tolérances dimensionnelles existent de part les autres éléments moulés sur la carte électronique qui interagissent avec la façade du tableau de commande. Or, les deux parties sont le plus souvent conçues et fabriquées indépendamment l'une de l'autre par des procédés différents. Les contraintes de fonctionnement électroniques liées à la conception et au montage de la carte ne prennent pas compte des contraintes mécanique de fonctionnement du bouton, et vice versa. L'assemblage implique des contraintes dimensionnelles très précises pour avoir une coopération totale des pièces entre elles. De plus, il existe des contraintes dimensionnelles entre les différents éléments du tableau de commande. L'ensemble de tous ces dimensionnements entre les parties électroniques qui ont des interfaces avec la façade du tableau de commande exigent des tolérances fines.

Tout décalage de la partie mobile par rapport à la partie fixe du bouton pouvant entraîner une altération du réglage du paramètre souhaité, l'invention propose de résoudre ce problème d'alignement et de précision du bouton en utilisant une détection optique.

Plus précisément, l'invention se rapporte à un tableau de commande de véhicule automobile munie d'au moins un bouton rotatif de réglage d'un paramètre relatif à un flux d'air propulsé par un appareil de ventilation, de chauffage et/ou de climatisation, comportant un encodeur optique à émission et réception sélective de lumière comprenant une partie mobile en rotation faisant saillie du tableau de commande et une partie fixe munie d'un dispositif de détection optique apte à coopérer avec la partie mobile pour émettre et recevoir la lumière. Le dispositif de détection optique comprend deux capteurs individuels comprenant chacun un émetteur de lumière formant un faisceau lumineux incident et un récepteur optique pour intercepter les faisceau lumineux réfléchis par la partie mobile ; caractérisé en ce que les deux capteurs sont décalés radialement l'un par rapport à l'autre.

Avantageusement, la partie fixe est munie d'un dispositif de détection optique comprenant au moins un émetteur de lumière formant un faisceau lumineux incident en direction de la partie mobile et le récepteur optique intercepte le faisceau lumineux réfléchi par la partie mobile et en déduire le déplacement angulaire et le sens de rotation de ladite partie mobile par rapport à ladite partie fixe, et la partie mobile comprend une pluralité d'incréments radiaux à surface réfléchissante constitués par une alternance de parties saillantes et de creux disposés sur au moins une couronne faisant face au dispositif de détection optique.

Selon un mode de réalisation de l'invention :
- les deux capteurs sont décalés angulairement l'un par rapport à l'autre;
- les deux capteurs sont sensiblement diamétralement opposés.

Selon un autre mode préféré de réalisation de l'invention :
- les parties saillantes présentant une dimension radiale constante, le dispositif de détection est positionnable avec un décalage radial vers l'extérieur ou l'intérieur à partir d'une position centrée sur la distance radiale jusqu'à la moitié de ladite dimension radiale.

Avantageusement, les récepteurs optiques sont décalés angulairement sensiblement qu'un des récepteurs optique reçoit un faisceau lumineux réfléchi par la partie mobile tandis que l'autre récepteur optique n'en reçoit pas.

De préférence, les parties saillantes sont régulièrement espacées les unes des autres.

D'autres caractéristiques, détails et avantages de l'invention ressortiront à la lecture de la description qui suit, faite en référence aux dessins annexés donnés à titre d'exemple et qui représentent respectivement :
- la figure 1, une vue schématisée en coupe d'un exemple de bouton rotatif conforme à la présente invention et présentant une partie fixe et une partie mobile en rotation,
- la figure 2, une vue de dessous de la partie mobile de la figure 1,
- la figure 3, une variante de réalisation de la figure 2,
- la figure 4, une vue du dessus de la partie fixe du bouton, selon une variante de réalisation de la figure 1,
- les figures 5 à 7, des demi vue de dessus d'autres variantes de réalisation du bouton conforme à la présente Invention,

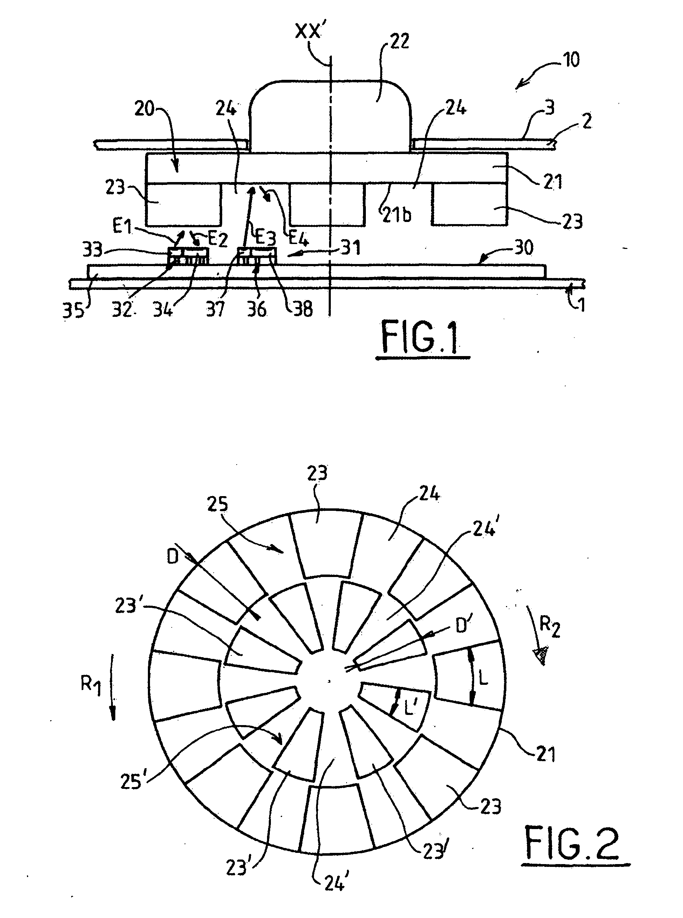

Les figures 1 à 3 représentent un bouton rotatif 10 conforme à la présente invention. Ce bouton 10 est dans cet exemple monté sur un tableau de commande 1 d'un habitacle de véhicule automobile, en particulier sur une console centrale, là où sont notamment effectués les réglages de la climatisation. Ce bouton 10 sert en particulier au réglage d'un paramètre relatif à un flux d'air propulsé par un appareil de ventilation, de chauffage et/ou de climatisation (non représenté), tel que la température, le débit ou la répartition dudit flux d'air. Ce bouton constitue un encodeur optique décrit ci-après.

A cet effet, le bouton rotatif de réglage 10 comprend une partie 20 mobile en rotation autour d'un axe XX' sensiblement perpendiculaire à la partie mobile, et une partie fixe 30 se présentant sous la forme d'une carte électronique fixée sur une platine 1, le tout étant monté typiquement sous une façade 2 d'un tableau de commande de type connu. La partie mobile 20 comporte un disque 21 surmonté d'un dôme 22 qui fait traverse un orifice de la façade 2 et fait saillie de celle-ci afin d'être accessible par le conducteur ou un passager du véhicule.

Dans l'exemple de réalisation, une surface externe 3 de la façade 2 présente des pictogrammes ou des indications relatives au paramètre de réglage, tel que des codes de couleur pour la température de l'air expulsé, des zones schématisées de l'habitacle pour symboliser le dégivrage, la ventilation haute, médiane ou la zone des pieds, ou des représentations graphiques ou alphanumériques pour symboliser le débit d'air.

Comme cela est illustré de manière plus détaillée sur la figure 2, une surface interne 21b du disque 21 présente des incréments disposés radialement sous la forme d'une première et d'une deuxième couronnes 25 et 25', appelées également piste. Ces incréments sont constitués chacun par un couple comprenant une partie saillante 23 ou 23' alternée avec un creux 24 ou 24'. Le nombre d'incrément est fonction du paramètre de réglage et de la résolution souhaitée. Ce nombre peut varier de quelques unités à quelques centaines, voire plusieurs milliers. Les incréments sont à surface réfléchissante, tout du moins dans la bande de fréquence de la lumière utilisé par l'encodeur. Ils sont dans le cas présent régulièrement espacés. Chaque partie saillante 23 ou 23' présente une dimension radiale commune D ou D' et une largeur moyenne L ou L'.

La partie fixe 30 du bouton encodeur optique 10 présente un dispositif de détection optique 31 comprenant, dans le mode de réalisation des figures 1 et 2, deux capteurs optiques 32 et 36 décalés radialement.

Le capteur optique 32 présente un émetteur 33 de lumière en direction du disque 21 et un récepteur optique 34, et le capteur 36 présente un émetteur 37 de lumière en direction du disque 21 et un récepteur optique 38. Ces capteurs 32 et 36 sont liés à une carte électronique à circuit imprimé 35 destinée au traitement des informations recueillis.

Le fonctionnement de ce bouton encodeur optique 10 est le suivant.

Un premier faisceau lumineux incident, illustré par la flèche E1, est émis par l'émetteur 33 du capteur 32 en direction de la surface interne 21b du disque 21. Selon que ce faisceau lumineux incident E1 frappe ou non une partie saillante 23, un deuxième faisceau lumineux E2 est réfléchi avec un angle tel qu'il est intercepté ou non par le récepteur optique 34.

Ainsi, si le premier faisceau lumineux incident E1 frappe une partie saillante 23, le récepteur optique 34 intercepte le deuxième faisceau lumineux réfléchi E2 et un signal binaire « 1 » est émis dans un circuit de traitement numérique (non représenté) de la carte électronique à circuit imprimé 35, signifiant qu'une partie saillante 23 a bien été illuminé par le premier faisceau lumineux incident E1.

Lorsque le bouton 10 tourne autour de l'axe XX', quel que soit le sens de rotation choisi, le premier faisceau lumineux incident E1 illumine ensuite un creux 24 et le récepteur optique 34 n'intercepte pas le deuxième faisceau lumineux réfléchi E2 car, par exemple, l'angle et/ou la profondeur dudit creux 24 le font sortir de la zone de réception du récepteur optique 34. Un signal binaire « 0 » est alors émis par le circuit de traitement numérique, signifiant que le bouton 10 a tourné.

En poursuivant la rotation du bouton 10 dans le même sens, le premier faisceau lumineux incident E1 frappe de nouveau une partie saillante 23 du disque 21 et un signal binaire « 1 » est alors émis dans le circuit de traitement numérique, signifiant que le bouton 10 a continué de tourner.

Le premier capteur 32 permet ainsi, en collaboration avec la couronne 25 d'incréments, de déterminer le nombre d'incréments parcourus par le disque 21 lors de sa rotation, c'est-à-dire le nombre de tours ou de fraction de tours, et ce sans tenir compte du sens de rotation.

En parallèle au fonctionnement du premier capteur 32, le deuxième capteur 36 permet quand à lui de déterminer le sens de rotation du bouton 10 en collaboration avec la deuxième couronne 25' d'incréments qui est concentrique avec la première couronne 25. A cet effet, ce deuxième capteur 36 est placé de telle sorte qu'un troisième faisceau lumineux incident E3 est émis par l'émetteur 37 en direction de la surface interne 21 b du disque 1, au niveau de la deuxième couronne 25', comme illustré sur la figure 1.

Ce troisième faisceau lumineux incident E3 est placé de telle façon que, dans une position initiale dans laquelle le premier faisceau lumineux incident E1 frappe une partie saillante 23, le troisième faisceau lumineux incident E3 illumine également une partie saillante 23' de la deuxième couronne d'incrément.

Ainsi, les incréments des couronnes 25 et 25' étant décalés angulairement, par exemple d'une partie saillante (ou d'un creux), lorsque le bouton encodeur optique 10 tourne :
- soit le troisième faisceau lumineux incident E3 frappe une zone en creux 24' de la deuxième couronne 25' alors que le premier faisceau lumineux incident E1 continue d'illuminer la partie saillante 23 d'origine (sens de rotation R1 de la figure 2) ;
- soit le troisième faisceau lumineux incident E3 continue d'illuminer la partie en saillie 23' d'origine alors que le premier faisceau E1 quitte le premier incrément et frappe une zone en creux 24 (sens de rotation R2 de la figure 2).

Dans le premier cas, un signal « 0 » est émis par le deuxième capteur 36 qui n'a pas reçu le quatrième faisceau lumineux réfléchi E4, et un signal 1 continue d'être émis par le premier capteur 32 qui reçoit le deuxième faisceau réfléchi E2.

Dans le second cas, un signal « 1 » continue d'être émis par le deuxième capteur 36 car il reçoit le quatrième faisceau réfléchi E4, et un signal « 0 » est émis par le premier capteur 32 qui ne reçoit plus le deuxième faisceau réfléchi E2.

Selon la séquence de « 1 » et de « 0 » émise, il est possible de déterminer immédiatement le sens de rotation R1 ou R2 du bouton 10 illustré sur la figure 2.

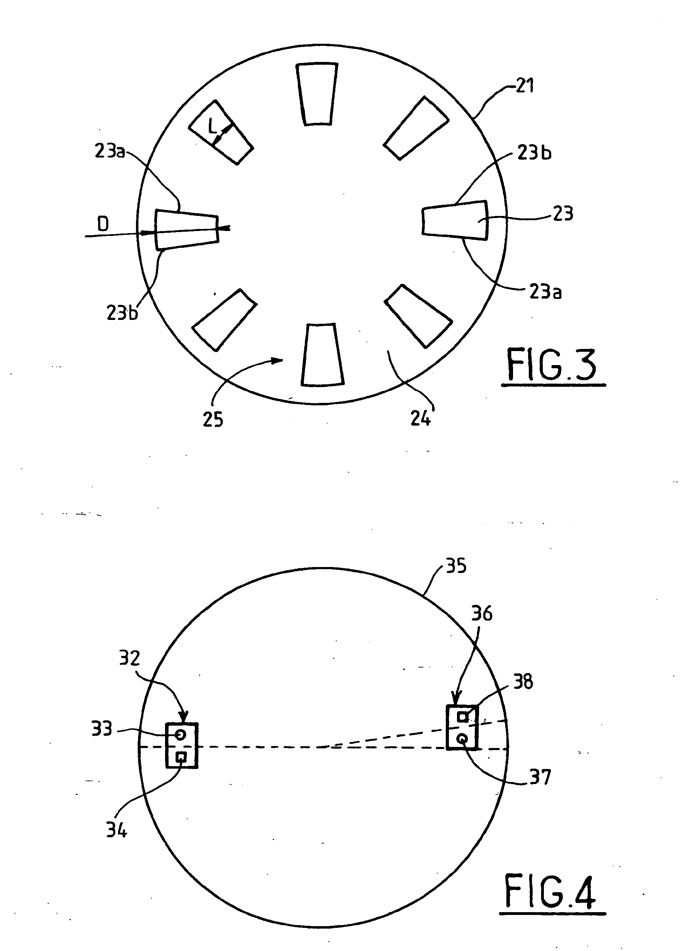

Dans une solution alternative illustrée par la figure 3, il n'y a qu'une seule couronne 25 d'incréments mais les deux capteurs 32 et 36 sont disposés très proches l'un de l'autre et décalés angulairement de sorte que les faisceaux incidents E1 et E3 sont dirigés l'un vers un bord 23a d'une partie saillante 23, l'autre vers l'autre bord 23b. Selon que les capteurs 32 et 36 reçoivent ou non les deuxièmes et quatrièmes faisceaux lumineux réfléchis E2 et E4, une séquence différente de « 0 » et de « 1 » sera émise en fonction du sens de rotation R1 ou R2 du bouton 10.

Le fait d'utiliser deux capteurs optiques 32 et 36 permet ainsi d'optimiser le fonctionnement du bouton en détectant à la fois le sens de rotation et la variation angulaire de la rotation dudit bouton, c'est-à-dire le pas.

Une solution alternative illustrée par la figure 4 est d'éloigner les deux capteurs 32 et 36, par exemple en les plaçant sensiblement face à face, mais en les décalant légèrement angulairement d'un demi creux 24 ou d'une demie partie saillante 23, de sorte que, lorsque l'émetteur 33 du premier capteur 32 pointe le premier faisceau lumineux incident E1 sur le bord 23a de la partie saillante 23 en face duquel il se trouve, l'émetteur 37 du deuxième capteur 36 pointe le troisième faisceau lumineux incident E3 sur le bord 23b de l'incrément 23 en face du quel il se trouve.

Le fonctionnement de ce bouton est identique à celui de la solution précédente mais il permet d'avoir des incréments très fins puisque les capteurs sont éloignés. Les séquences de « 1 » et de « 0 » permettent de la même façon de déterminer le sens de rotation R1 ou R2 de la partie mobile 20 du bouton 10, ainsi bien entendu que la fraction de tours parcouru par celle-ci. Il suffit en fait de décaler angulairement les émetteurs de n fois la moitié de la largeur moyenne L d'une partie saillante, n étant un entier impair supérieur ou égal à 1, pour obtenir ce résultat. Un décalage de 180° plus ou moins la moitié de la largeur moyenne L d'une partie saillante est ainsi illustrée sur la figure 4.

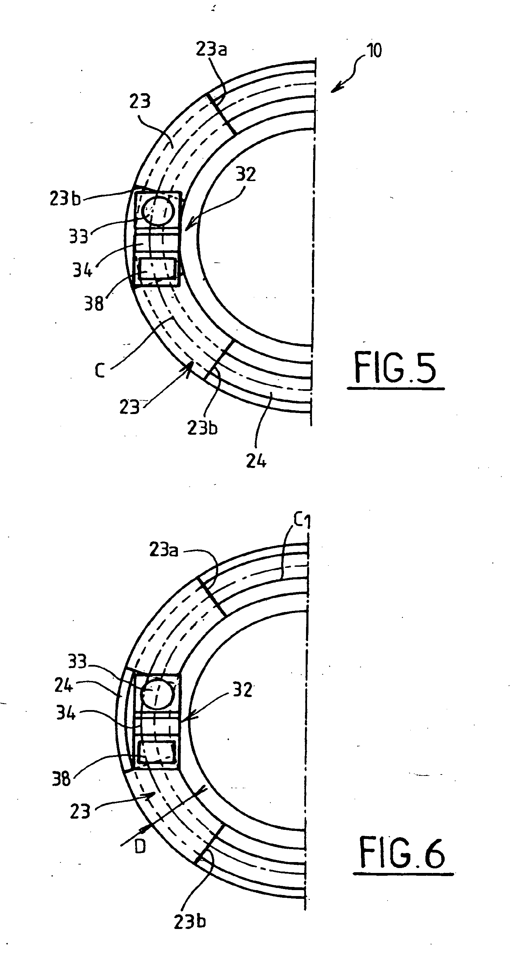

Les figures 5 à 7 illustrent d'autres variantes de réalisation dans lesquelles le dispositif de détection optique 31 comprend un seul capteur 32 équipé d'un unique émetteur de lumière 33 et deux récepteurs optiques 34 et 38. Le mode de fonctionnement de ce bouton 10 est similaire aux précédents. L'émetteur de lumière 33 émet un premier faisceau lumineux incident E1 en direction de la surface interne 21 b du disque 21. Ce premier faisceau lumineux incident E1 frappe ou non une partie saillante 23 du disque 21. Si le premier détecteur optique 34 intercepte un deuxième faisceau lumineux réfléchi E2, cela signifie que le premier faisceau lumineux incident à illuminé une partie saillante 23 et un signal binaire « 1 » est alors émis pour le premier détecteur optique 34. Le deuxième détecteur optique 38 étant décalé angulairement par rapport au premier détecteur optique 34, soit le deuxième faisceau lumineux réfléchi est intercepté par ce deuxième capteur 38, soit il ne l'est pas. Dans le premier cas, cela signifie que le bouton tourne dans un premier sens et dans le second cas, cela signifie que le bouton tourne dans l'autre sens selon la séquence de « 1 » et de « 0 » émise.

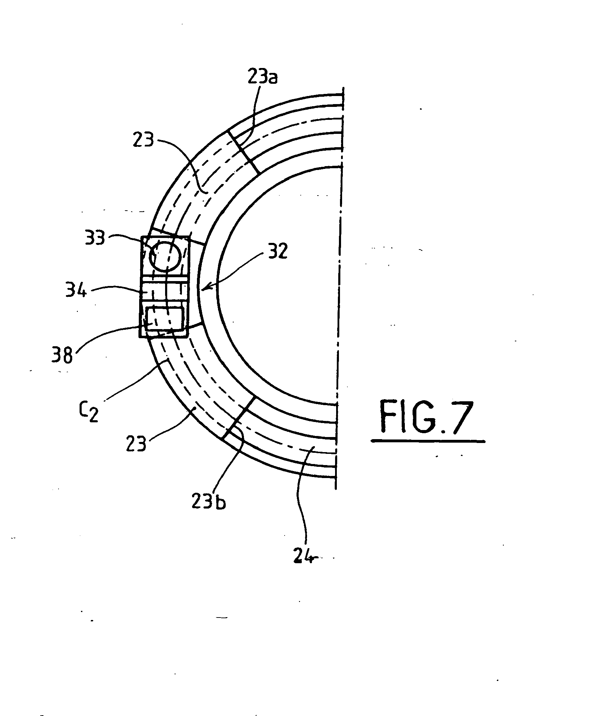

Sur la figure 5, le capteur 32 est placé sur un cercle C passant sensiblement par le milieu des parties saillantes 23. Sur les figures 6 et 7, le dispositif de détection optique 31 est décalé radialement intérieurement ou extérieurement de plus ou moins la moitié de la dimension radiale D de chaque partie saillante 23, sans que cela n'ait d'influence sur la précision de la mesure. Par exemple dans le cas ou chaque partie saillante mesure radialement sensiblement 2 mm, le capteur 32 de la figure 6 est sensiblement placé sur un cercle C1 concentrique et de rayon inférieur de 1 mm à celui du cercle C nominal, tandis que sur la figure 7, le capteur 32 est sensiblement placé sur un cercle C2 concentrique et de rayon supérieur de 1 mm à celui du cercle C nominal. Cette solution permet de compenser les éventuelles différences d'alignement entre la partie fixe et la partie mobile du bouton 10, ces défauts d'alignement étant principalement dus aux tolérances de fabrication et de positionnement des pièces.

Ainsi, il est possible de prévoir un plus grand nombre d'émetteur et/ou de récepteurs optiques. Les capteurs peuvent être décalés à la fois angulairement et radialement.

De même, il est envisageable que seule la partie en saillie 23 ou en creux 24 soit réfléchissante.

En remplacement de ce type d'encodeur optique à « créneaux », il est également possible d'alterner, sur la surface interne 21 b du disque 21, des parties qui réfléchissent la lumière incidente avec un angle tel que la lumière émise est reçue par un capteur correspondant, et des parties qui réfléchissent la lumière incidente avec un autre angle faisant sortir la lumière émise de la zone de réception du capteur. Pour cela, il est possible d'utiliser des zones à facettes inclinées ou bien des zones recouvertes de matériaux possédant des indices de réfraction de la lumière différents.

Les incréments peuvent être localement plus ou moins resserrés angulairement les uns des autres sur leur couronne selon le degré de précision souhaité, notamment en fonction du paramètre de l'air à modifier lorsque le bouton est tourné. Ainsi, sur par exemple un quart de tour, il peut être souhaitable d'avoir des incréments plus rapprochés pour affiner le débit d'air ou sa température.

De même, l'encodeur optique peut fonctionner sur un mode de transmission et non plus de réflexion, en plaçant le ou les émetteur(s) d'un côté du disque et les récepteur optiques de l'autre côté du disque, et en prévoyant que les zones entre les incréments soient transparentes au rayon lumineux émis par le ou les émetteur(s).

## Revendications

1. Tableau de commande de véhicule automobile muni d'au moins un bouton rotatif (10) de réglage d'un paramètre relatif à un flux d'air propulsé par un appareil de ventilation, de chauffage et/ou de climatisation, comportant un encodeur optique à émission et réception sélective de lumière comprenant une partie mobile en rotation (20) faisant saillie du tableau de commande et une partie fixe (30) munie d'un dispositif de détection optique (31) apte à coopérer avec la partie mobile (20) pour émettre et recevoir la lumière, le dispositif de détection optique (31) comprenant deux capteurs individuels (32, 36) comprenant chacun un émetteur de lumière (33, 37) formant un faisceau lumineux (E1 ; E3) incident et un récepteur optique (34, 38) pour intercepter les faisceaux lumineux (E2 ; E4) réfléchis par la partie mobile (20), **caractérisé en ce que** les deux capteurs (32, 36) sont décalés radialement l'un par rapport à l'autre.

2. Tableau de commande selon la revendication 1, dans lequel l'émetteur de lumière (33 ; 37) forme un faisceau lumineux (E1 ; E3) incident en direction de la partie mobile (20) et le récepteur optique (34, 38) intercepte le faisceau lumineux (E2 ; E4) réfléchi par la partie mobile (20) et en déduit le déplacement angulaire et le sens de rotation de ladite partie mobile (20) par rapport à ladite partie fixe (30).

3. Tableau de commande selon l'une quelconque des revendications 1 ou 2, **caractérisé en ce que** la partie mobile (20) comprend une pluralité d'incréments radiaux à surface réfléchissante comprenant une alternance de parties saillantes (23 ; 23') et de creux (24 ; 24') disposés sur au moins une couronne (25 ; 25') faisant face au dispositif de détection optique (31).

4. Tableau de commande selon l'une quelconque des revendications précédentes, dans lequel les deux capteurs (32, 36) sont décalés angulairement l'un par rapport à l'autre.

5. Tableau de commande selon la revendication 4, dans lequel les deux capteurs (32, 36) sont sensiblement diamétralement opposés.

6. Tableau de commande selon l'une quelconque des revendications 3 à 5, dans lequel, les parties saillantes (23 ; 23') présentent une dimension radiale (D) constante, le dispositif de détection (31) est positionnable avec un décalage radial vers l'extérieur ou l'intérieur, à partir d'une position centrée sur la distance radiale (D), jusqu'à la moitié de ladite dimension radiale (D).

7. Tableau de commande selon l'une quelconque des revendications 4 à 6, dans lequel les récepteurs optiques (34, 38) sont décalés angulairement de sorte qu'un des récepteurs optique (34 ; 38) reçoit un faisceau lumineux réfléchi par la partie mobile (21) tandis que l'autre récepteur optique (38 ; 24) n'en reçoit pas.

8. Tableau de commande selon l'une quelconque des revendications 3 à 7, dans lequel les parties saillantes (23, 23') sont régulièrement espacées les unes des autres.

9. Tableau de commande selon l'une quelconque des revendications précédentes, dans lequel le paramètre à régler est choisi parmi la température, le débit ou la zone d'éjection dudit flux d'air.

## Claims

1. Control panel for a motor vehicle provided with at least one rotary knob (10) for adjusting a parameter relating to an airstream propelled by a ventilation, heating and/or air-conditioning apparatus, comprising an optical encoder with light-selective transmission and reception comprising a part (20) that moves rotation-wise projecting from the control panel and a fixed part (30) provided with an optical detection device (31) able to cooperate with the moving part (20) to send and receive the light, the optical detection device (31) comprising two individual sensors (32, 36) each comprising a light emitter (33, 37) forming an incident light beam (E1; E3) and an optical receiver (34, 38) for intercepting the light beams (E2; E4) reflected by the moving part (20), **characterized in that** the two sensors (32, 36) are radially offset relative to each other.

2. Control panel according to Claim 1, in which the light emitter (33; 37) forms an incident light beam (E1; E3) towards the moving part (20) and the optical receiver (34, 38) intercepts the light beam (E2; E4) reflected by the moving part (20) and deduces therefrom the angular displacement and the direction of rotation of said moving part (20) relative to said fixed part (30).

3. Control panel according to either of Claims 1 or 2, **characterized in that** the moving part (20) comprises a plurality of radial increments with reflecting surface comprising alternating projecting parts (23; 23') and hollow parts (24; 24') arranged on at least one disc (25; 25') facing the optical detection device (31).

4. Control panel according to any one of the preceding claims, in which the two sensors (32, 36) are angularly offset relative to each other.

5. Control panel according to Claim 4, in which the two sensors (32, 36) are substantially diametrically opposite.

6. Control panel according to any one of Claims 3 to 5, in which the projecting parts (23; 23') have a constant radial dimension (D), the detection device (31) can be positioned with a radial offset towards the outside or the inside, from a position centred on the radial distance (D), to half said radial dimension (D).

7. Control panel according to any one of Claims 4 to 6, in which the optical receivers (34, 38) are angularly offset so that one of the optical receivers (34; 38) receives a light beam reflected by the moving part (21) whereas the other optical receiver (38; 24) does not receive it.

8. Control panel according to any one of Claims 3 to 7, in which the projecting parts (23; 23') are evenly spaced relative to each other.

9. Control panel according to any one of the preceding claims, in which the parameter to be adjusted is chosen from the temperature, the flow rate or the area of ejection of said airstream.

## Patentansprüche

1. Bedienfeld eines Kraftfahrzeugs, das mit mindestens einem Drehknopf (10) zur Regelung eines Parameters bezüglich eines von einem Belüftungs-, Heiz- und/oder Klimatisierungsgerät angetriebenen Luftstroms versehen ist, der einen optischen Codierer mit selektivem Emittieren und Empfangen von Licht aufweist, der einen drehbeweglichen Teil (20), der aus dem Bedienfeld vorsteht, und einen ortsfesten Teil (30) enthält, der mit einer optischen Erfassungsvorrichtung (31) versehen ist, die mit dem beweglichen Teil (20) zusammenwirken kann, um das Licht zu emittieren und zu empfangen, wobei die optische Erfassungsvorrichtung (31) zwei einzelne Sensoren (32, 36) enthält, die je einen Lichtemitter (33, 37), der einen einfallenden Lichtstrahl (E1; E3) formt, und einen optischen Empfänger (34, 38) enthalten, um die vom beweglichen Teil (20) reflektierten Lichtstrahlen (E2; E4) aufzufangen, **dadurch gekennzeichnet, dass** die zwei Sensoren (32, 36) radial zueinander verschoben sind.

2. Bedienfeld nach Anspruch 1, bei dem der Lichtemitter (33; 37) einen einfallenden Lichtstrahl (E1; E3) in Richtung des beweglichen Teils (20) formt und der optische Empfänger (34, 38) den vom beweglichen Teil (20) reflektierten Lichtstrahl (E2; E4) auffängt und daraus die Winkelverschiebung und die Drehrichtung des beweglichen Teils (20) bezüglich des ortsfesten Teils (30) ableitet.

3. Bedienfeld nach einem der Ansprüche 1 oder 2, **dadurch gekennzeichnet, dass** der bewegliche Teil (20) mehrere radiale Inkremente mit reflektierender Fläche enthält, die eine abwechselnde Anordnung von vorstehenden Teilen (23; 23') und von Vertiefungen (24; 24') enthalten, die auf mindestens einem Kranz (25; 25') angeordnet sind, der der optischen Erfassungsvorrichtung (31) gegenüberliegt.

4. Bedienfeld nach einem der vorhergehenden Ansprüche, bei dem die zwei Sensoren (32, 36) winkelmäßig zueinander verschoben sind.

5. Bedienfeld nach Anspruch 4, bei dem die zwei Sensoren (32, 36) einander im Wesentlichen diametral gegenüberliegen.

6. Bedienfeld nach einem der Ansprüche 3 bis 5, bei dem bei konstanter radialer Abmessung (D) der vorstehenden Teile (23; 23') die Erfassungsvorrichtung (31) mit einer radialen Verschiebung nach außen oder nach innen ausgehend von einer Stellung, die auf den radialen Abstand (D) zentriert ist, bis zur Hälfte der radialen Abmessung (D) positioniert werden kann.

7. Bedienfeld nach einem der Ansprüche 4 bis 6, bei dem die optischen Empfänger (34, 38) winkelmäßig so verschoben sind, dass einer der optischen Empfänger (34; 38) einen vom beweglichen Teil (21) reflektierten Lichtstrahl empfängt, während der andere optische Empfänger (38; 24) keinen empfängt.

8. Bedienfeld nach einem der Ansprüche 3 bis 7, bei dem die vorstehenden Teile (23, 23') einen regelmäßigen Abstand zueinander haben.

9. Bedienfeld nach einem der vorhergehenden Ansprüche, bei dem der zu regelnde Parameter unter der Temperatur, dem Durchsatz oder der Ausstoßzone des Luftstroms ausgewählt wird.
